# EUROPÄISCHE PATENTSCHRIFT

(11) **EP 0 895 063 B1**
(45) Veröffentlichungstag und Bekanntmachung des Hinweises auf die Patenterteilung: **08.10.2003**
(21) Anmeldenummer: 98112519.8
(22) Anmeldetag: 07.07.1998
(51) Int. Cl.: G01D 5/245, G01D 5/36, H03M 1/30

(54) **Positionsmesseinrichtung**
Position measuring device
Dispositif de mesure de position

(30) Priorität: 30.07.1997 AT 129097
(43) Veröffentlichungstag der Anmeldung: 03.02.1999
(73) Patentinhaber: Dr. Johannes Heidenhain GmbH, 83292 Traunreut (DE)
(72) Erfinder: Peterlechner, Andreas, 5121 St. Radegund (AT)

(56) Entgegenhaltungen:
- EP-A- 0 421 131
- AT-B- 396 840
- DE-A- 3 526 206
- DE-B- 1 046 332
- GB-A- 2 090 968

## Beschreibung

Die Erfindung betrifft eine Positionsmeßeinrichtung mit einer inkrementalen Teilung und einer Bezugsspur sowie einer Referenzmarke.

Eine derartige Positionsmeßeinrichtung ist aus der DE 35 26 206 A1 bekannt. Auf einem Maßstab ist eine Maßverkörperung in Form einer inkrementalen Teilung und eine Bezugsspur mit einem kontinuierlichen transparenten und einem direkt darauffolgenden kontinuierlichen opaken Feld vorgesehen. Diese Bezugsspur wird von einem Fenster einer Abtasteinheit abgetastet, um im transparenten Feld ein kontinuierlich niedriges und im opaken Feld ein kontinuierlich hohes Abtastsignal zu erhalten und um die beiden Felder somit unterscheiden zu können.

Diese Anordnung hat den Nachteil, daß bei der Abtastung des Überganges vom opaken zum transparenten Feld das Abtastsignal relativ langsam ansteigt. Um eine sichere Unterscheidung der beiden Feldbereiche anhand des Abtastsignals zu erreichen, ist es erforderlich, daß der Unterschied zwischen dem kontinuierlich niedrigen und hohen Abtastsignal möglichst groß ist. Dies kann nach dem Stand der Technik durch die Verwendung eines in Meßrichtung relativ langen Fensters in der Abtasteinheit erreicht werden.

Dies hat aber zur Folge, daß der Übergangsbereich des Abtastsignals vom niedrigen zum hohen Signalpegel relativ breit ist. Mit dem Abtastsignal kann keine Bezugsposition eindeutig bestimmt werden, weshalb eine separate Referenzmarke erforderlich ist. Auch mit dem durch Abtastung der Bezugsspur und der Referenzmarke resultierenden Abtastsignal können die beiden Feldbereiche rechts und links der Bezugsposition nicht eindeutig voneinander unterschieden werden.

Aus der AT 396 840 B ist eine weitere Positionsmeßeinrichtung bekannt, bei der neben einer inkrementalen Teilung kontinuierliche transparente und opake Feldbereiche auf einem Maßstab angebracht sind, um den rechten und linken Bereich einer Bezugsposition zu unterscheiden. In einer Bezugsspur sind die Feldbereiche in der Reihenfolge transparent und opak und in einer zweiten Bezugsspur komplementär dazu opak und transparent angeordnet. An der Bezugsposition sind beide Bezugsspuren transparent. Von jeder der beiden Bezugsspuren wird ein Abtastsignal erzeugt und die beiden Abtastsignale sind in Differenz geschaltet.

Auch bei dieser Anordnung steigt das resultierende Abtastsignal relativ langsam an und die zwei Bezugsspuren erhöhen die Baugröße der Positionsmeßeinrichtung.

In der DE 20 46 332 C3 ist eine photoelektrische Vorrichtung zum gegenseitigen Ausrichten zweier Gegenstände beschrieben. Auf einem der beiden Gegenstände sind zwei parallele Bezugsspuren angeordnet, jede Bezugsspur wird von einem Muster einer Abtasteinheit abgetastet. Jede Bezugsspur besteht aus einem transparenten und einem opaken kontinuierlichen Feld. Am Übergang der beiden Felder ist jede Bezugsspur mit einem Muster aus einer Folge von transparenten und opaken Feldern ausgebildet. Das Muster der Abtasteinheit ist zu diesem Muster komplementär. Bei der Bewegung der Abtasteinheit vom opaken Feld einer Bezugsspur zum transparenten Feld dieser Bezugsspur wird ein Zustand erreicht, bei dem ein steiler Anstieg des Abtastsignales erfolgt, indem gleichzeitig mehrere transparente Felder der Bezugsspur mit transparenten Bereichen der Abtasteinheit vom nicht überlappenden Zustand in einen sich überlappenden Zustand übergehen. Nachteilig ist aber, daß anhand dieses Abtastsignals keine eindeutige Bezugsposition festgelegt werden kann, da im Übergangsbereich gleiche Signalpegel an mehreren Orten erzeugt werden. Um diese Mehrdeutigkeit auszuschließen, werden die beiden Abtastsignale der beiden Bezugsspuren in Differenz geschaltet. Das Differenzsignal weist nur einen einzigen eindeutigen steil ansteigenden Bereich auf. Nachteilig ist aber, daß die Differenz zwischen dem niedrigen und dem hohen Signalpegel dadurch sehr gering ist. Weiterhin sind zur Erzeugung des Differenzsignales zwei Bezugsspuren und zwei Abtastfenster erforderlich, was die Baugröße erhöht. Die beiden Bezugsspuren sind senkrecht zur Meßrichtung voneinander beabstandet angeordnet, dies hat zur Folge, daß das Differenzsignal erheblich durch Verkippungen zwischen der Abtasteinheit und dem Träger der Bezugsspuren beeinflußt wird. Je steifer der Signalanstieg des Differenzsignals ist, desto empfindlicher ist die Vorrichtung gegenüber Verkippungen, da bereits bei geringen Verkippungen das Differenzsignal innerhalb eines großen Bereiches zu Null werden kann.

In der JP 5-15213 B2 ist eine absolute Positionsmeßeinrichtung mit mehreren Codespuren beschrieben. Jede Codespur besteht aus abwechselnd opaken und transparenten Feldern. Am Übergang zwischen zwei Feldern ist jeweils ein Muster von aufeinanderfolgenden transparenten und opaken Feldern vorgesehen, das von einem Muster der Abtasteinrichtung abgetastet wird, um einen möglichst steilen Signalanstieg der analogen Abtastsignale zu erhalten. Die analogen Abtastsignale werden digitalisiert und ein absolutes Codewort gebildet. Bei einem Ausführungsbeispiel ist parallel zu den Codespuren eine Inkrementalspur angeordnet. Keiner der Übergänge zwischen den opaken und transparenten Feldern der Codespuren dient aber zur Erzeugung eines Bezugssignales, das einem aus der Inkrementalteilung abgeleiteten Zählsignal zugeordnet ist.

Es sind auch keine Maßnahmen und Mittel zur Erzielung einer derartigen und eindeutigen Zuordnung angegeben. Der Übergangsbereich zwischen zwei Feldern bildet somit keine Referenzmarke.

Der Erfindung liegt die Aufgabe zugrunde, eine Positionsmeßeinrichtung anzugeben die einfach und platzsparend aufgebaut ist, und bei der Meßbereiche beidseitig einer Bezugsposition eindeutig anhand des Signalpegels eines Abtastsignals unterscheidbar sind. Weiterhin soll das Abtastsignal am Übergang von einem zum anderen Meßbereich eine große Steigung aufweisen, um eine Bezugsposition eindeutig und hochgenau entsprechend einem Zählschritt der inkrementalen Positionsmessung bestimmen zu können.

Diese Aufgabe wird von einer Positionsmeßeinrichtung mit den Merkmalen des Patentanspruches 1 gelöst.

Vorteilhafte Ausgestaltungen sind in den abhängigen Patentansprüchen angegeben.

Die Vorteile einer erfindungsgemäß ausgestalteten Positionsmeßeinrichtung liegen darin, daß zur eindeutigen Unterscheidung mehrerer Meßbereiche nur eine Bezugsspur auf dem Maßstab erforderlich ist, und daß das Abtastsignal an einer Bezugsposition zwischen diesen Meßbereichen eine große Steigung aufweist. In Verbindung mit einer parallel zu dieser Bezugsspur angeordneten inkrementalen Maßverkörperung hat dies den besonderen Vorteil, daß aus dem Abtastsignal eine Bezugsposition abgeleitet werden kann, die eindeutig einem Zählschritt zuordbar ist.

Anhand der Zeichnungen wird die Erfindung näher erläutert.

Es zeigt
- Figur 1: einen Maßstab einer ersten Positionsmeßeinrichtung;
- Figur 2: eine Abtasteinheit zur Abtastung des Maßstabes gemäß Figur 1;
- Figur 3: einen Signalverlauf der analogen inkrementalen Meßsignale der Abtasteinheit gemäß Figur 2;
- Figur 4: die aus den Meßsignalen gemäß Figur 3 abgeleiteten Zählsignale in digitaler Form;
- Figur 5: das analoge Abtastsignal der Bezugsspur;
- Figur 6: das Abtastsignal gemäß Figur 5 in digitaler Form;
- Figur 7: den Signalverlauf der analogen inkrementalen Meßsignale der Abtasteinheit gemäß Figur 2;
- Figur 8: die digitalisierten Meßsignale aus Figur 7;
- Figur 9: das analoge Abtastsignal der Bezugsspur gemäß Figur 2;
- Figur 10: das digitalisierte Abtastsignal der Bezugsspur;
- Figur 11: das digitalisierte Abtastsignal gemäß Figur 10 logisch verknüpft mit den Meßsignalen gemäß Figur 8;
- Figur 12: eine Schaltung zur Verarbeitung und Erzeugung der Signale gemäß der Figuren 7 bis 11;
- Figur 13: einen Maßstab einer zweiten Positionsmeßeinrichtung;
- Figur 14: eine Abtasteinheit zur Abtastung des Maßstabes gemäß Figur 13;
- Figur 15: einen Signalverlauf des Abtastsignals der Abtasteinheit gemäß Figur 14;
- Figur 16: einen Maßstab einer dritten Positionsmeßeinrichtung,
- Figur 17: eine Abtasteinheit zur Abtastung des Maßstabes gemäß Figur 16 und
- Figur 18: einen Signalverlauf des Abtastsignals der Abtasteinheit gemäß Figur 17.

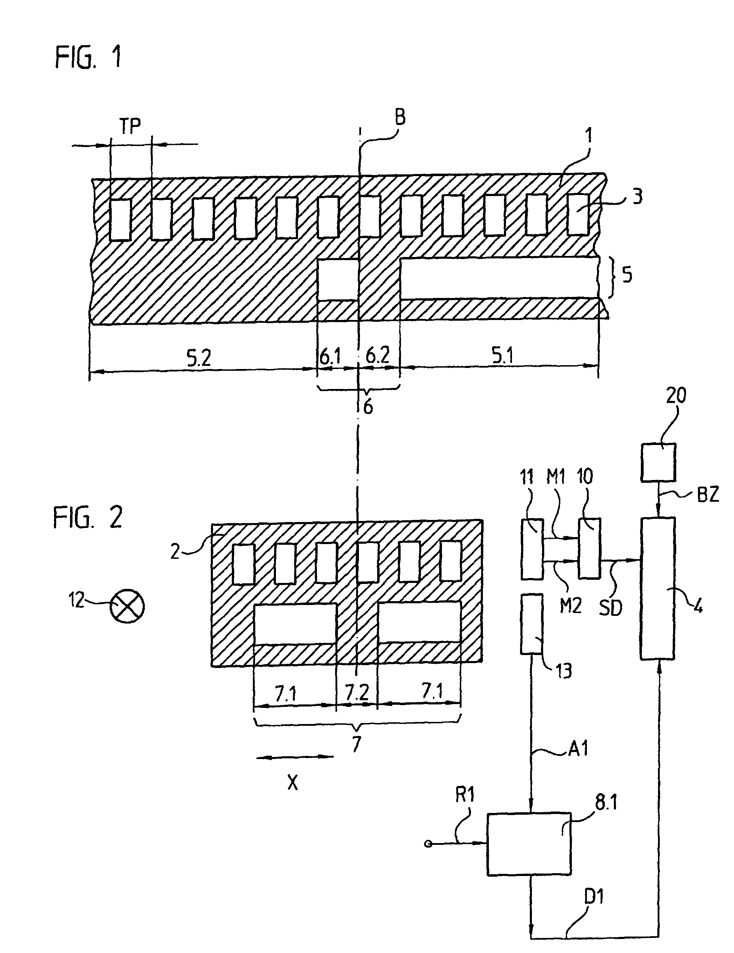

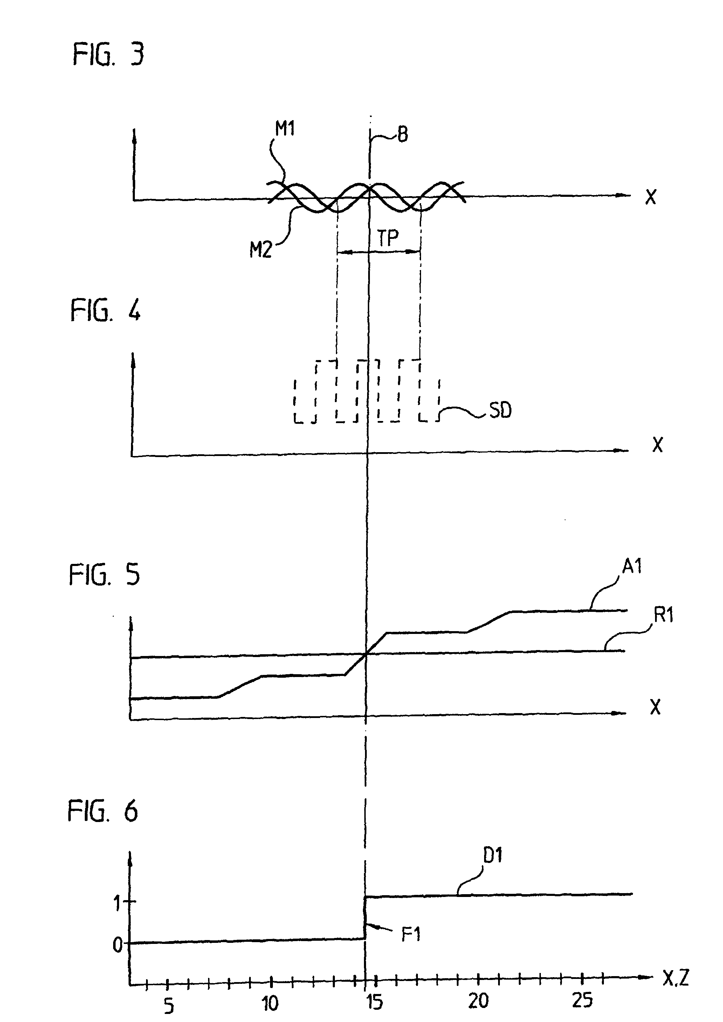

In den Figuren 1 bis 6 ist ein erstes Ausführungsbeispiel der Erfindung dargestellt. In Figur 1 ist ein Maßstab 1 und in Figur 2 eine Abtasteinheit 2 zur Abtastung des Maßstabes 1 gezeigt. Auf dem Maßstab 1 ist eine Maßverkörperung in Form einer inkrementalen Teilung 3 der Teilungsperiode TP vorgesehen. Die inkrementale Teilung 3 besteht aus periodisch in Meßrichtung X angeordneten transparenten und opaken Bereichen. Zur Abtastung der inkrementalen Teilung 3 wird die Abtasteinheit 2 in bekannter Weise relativ zum Maßstab 1 in Meßrichtung X verschoben, dabei werden von der Abtasteinheit 2 mehrere gegeneinander phasenverschobene analoge Meßsignale M1, M2 erzeugt, die interpoliert werden. Die Interpolation erfolgt in einer Interpolationseinheit 10 indem jede Teilungsperiode TP in mehrere Bereiche unterteilt wird, wobei jeder Bereich einem Zählschritt Z entspricht. Ein Zählschritt Z ist also ein Bruchteil einer Periode TP der Meßsignale M1, M2. Im Beispiel sind die analogen Meßsignale M1, M2 zwei um 90° gegeneinander phasenverschobene sinusförmige Abtastsignale, wie in Figur 3 dargestellt. In Figur 4 ist ein digitalisiertes Meßsignal SD dargestellt, das durch Interpolation der analogen, sinusförmigen Meßsignale M1, M2 der Photodetektoren 11 erzeugt wurde. Dieses positionsabhängige Meßsignal SD wird einem Zähler 4 zugeführt, welcher durch Zählung der Flanken des digitalen Meßsignales SD die Momentanposition der Abtasteinheit 2 relativ zum Maßstab 1 hochgenau ermittelt. Der Abstand zweier zählbarer Flanken entspricht einem Zählschritt Z.

Auf dem Maßstab 1 befindet sich neben der inkrementalen Teilung 3 eine Bezugsspur 5 mit in Meßrichtung X hintereinander angeordneten kontinuierlichen unterschiedlich ausgebildeten Feldern 5.1 und 5.2. Das eine Feld 5.2 ist opak und das andere Feld 5.1 ist transparent. Jedes Feld 5.1 und 5.2 reicht über eine Vielzahl von Teilungsperioden TP der inkrementalen Teilung 3. Am Übergang vom opaken Feld 5.2 zum transparenten Feld 5.1 ist ein Muster 6 von in Meßrichtung X aufeinanderfolgenden transparenten Feldern 6.1 und opaken Feldern 6.2 vorgesehen.

Zur Abtastung der Bezugsspur 5 besitzt die Abtasteinheit 2 ein Muster 7 aus in Meßrichtung X aufeinanderfolgenden transparenten Bereichen 7.1 und opaken Bereichen 7.2. Die transparenten Bereiche 7.1 sind in Meßrichtung X betrachtet mindestens doppelt so breit, wie die transparenten Felder 6.1 des Musters 6 der Bezugsspur 5. In Figur 2 ist eine Lichtquelle 12, ein Photedetektor 13 und die Draufsicht einer Abtastplatte der Abtasteinheit 2 nur schematisch dargestellt. In an sich bekannter Weise ist der Abtastplatte der Photodetektor 13 zur Erzeugung eines Abtastsignales A1 bei der Abtastung der Bezugsspur 5 zugeordnet. Das vom Photedetektor 13 erzeugte analoge Abtastsignal A1 ist in Figur 5 dargestellt. Es ist ersichtlich, daß bei der Bewegung der Abtasteinheit 2 vom linken opaken Feld 5.2 ausgehend ein niedriger kontinuierlicher Signalpegel entsteht. Erreicht ein transparenter Bereich 7.1 der Abtasteinheit 2 ein transparentes Feld 6.1 der Bezugsspur 5, steigt der Pegel des Abtastsignals A1 leicht an. Das Muster 6 der Bezugsspur 5 und das Muster 7 der Abtasteinheit 2 sind derart aufeinander abgestimmt, daß bei der Bewegung der Abtasteinheit 2 vom opaken Feld 5.2 in Richtung des transparenten Feldes 5.1 der Pegel des Abtastsignales A1 in einer Bezugsposition B stark ansteigt. Erreicht wird dies dadurch, daß an dieser Bezugsposition B gleichzeitig mehrere transparente Bereiche 7.1 des Musters 7 der Abtasteinheit 2 mit transparenten Feldern 6.1, 5.1 der Bezugsspur 5 des Maßstabes 1 vom sich nicht überlappenden Zustand in einen sich überlappenden Zustand übergehen. Im dargestellten Beispiel sind es zwei Bereiche 7.1, die sich gleichzeitig mit transparenten Feldern 6.1, 5.1 des Maßstabes 1 überdecken. Je mehr transparente Felder 6.1 und Bereiche 7.1 zur Verfügung stehen, desto steiler steigt der Signalpegel im Bereich der Bezugspositon B an, und um so genauer kann die Bezugsposition B aus dem Abtastsignal A1 gewonnen werden.

Im dargestellten Beispiel wird die Bezugsposition B durch Triggerung des analogen Abtastsignals A1 gewonnen, indem das analoge Abtastsignal A1 mit einem Referenzsignal R1 in einem Vergleicher 8.1 verglichen wird. Am Ausgang des Vergleichers 8.1 steht ein digitales Signal D1 an, welches in Figur 6 gezeigt ist. An der Bezugsposition B besitzt das Signal D1 ein Merkmal in Form einer ansteigenden Flanke F1, die einem vorgegebenen Zählschritt BZ eindeutig zugeordnet ist. Auf der linken Seite der Bezugsposition B ist dieses Signal D1 = 0 und im rechten Bereich ist dieses Signal D1 = 1. Durch das Signal A1 bzw. D1 kann an jeder beliebigen Relativposition zwischen Abtasteinheit 2 und Maßstab 1 festgestellt werden, ob sich die Abtasteinheit 2 rechts oder links von der Bezugsposition B befindet. In jeder beliebigen Lage kann gezielt die Bezugsposition B angefahren werden. Die eindeutige Bestimmung der Bezugsposition B ist bei inkrementalen, relativ messenden Systemen erforderlich, um die Messung auf eine definierte Maßstabstelle (Bezugsposition) beziehen zu können. Die Bezugsposition B dient dazu, um nach Betriebsunterbrechungen und Stromausfall einen absoluten Positionsmeßwert, bezogen auf die Bezugsposition B, wieder herzustellen. Hierzu wird beim Auftreten der Flanke F1 des Signals D1 der Zähler 4 auf den vorgegebenen Bezugszählerstand BZ gesetzt. Dieser Bezugszählerstand BZ wird dabei von einem Speicher 20 in den Zähler 4 übertragen. Im dargestellten Beispiel muß der Zähler 4 auf den Bezugszählerstand BZ=15 gesetzt werden, um wieder korrekt von der Bezugsposition B ausgehend weiterzählen zu können. Der Bezugszählerstand BZ kann auch einen anderen Wert haben, beispielsweise kann BZ=0 sein. Bei Winkelmeßsystemen kann zusätzlich ein Umdrehungszähler mit dem an der Bezugsposition B generierten Abtastsignal A1, D1 angesteuert werden.

Die Muster 6 und 7 des Maßstabes 1 und der Abtasteinheit 2 sind weiterhin derart aufeinander abgestimmt, daß das Abtastsignal A1 bei der Abtastung des Musters 6 nach Durchlaufen des steilen Anstiegs nicht mehr unter ein Niveau abfällt, das gleich oder niedriger ist als das Niveau des Abtastsignals A1 bei der Abtastung des Musters 6 vor Durchlaufen des steilen Anstiegs. Das bedeutet, daß sich vor Erreichen der Bezugsposition B immer weniger transparente Felder 6.1 mit transparenten Bereichen 7.1 bzw. sich weniger transparente Flächen überlappen, als nach Erreichen der Bezugsposition B.

Die Anzahl der gleichzeitig in den überlappenden Zustand übergehenden Felder 6.1 und Bereiche 7.1 bestimmt die Steigung des Abtastsignals A1 im Bereich der Bezugsposition B. Sie ist so gewählt, daß während des Betriebes der Positionsmeßeinrichtung der Übergang des digitalen Abtastsignals D1 von 0 auf 1 immer innerhalb eines bestimmten Zählschrittes Z liegt. Im dargestellten Beispiel wird die Bezugsposition B dem Zählschritt Z = 15 (Zählerstand) zugeordnet. Diese Zuordnung muß auch bei Temperaturänderungen, Verschmutzung und Alterung gewährleistet sein.

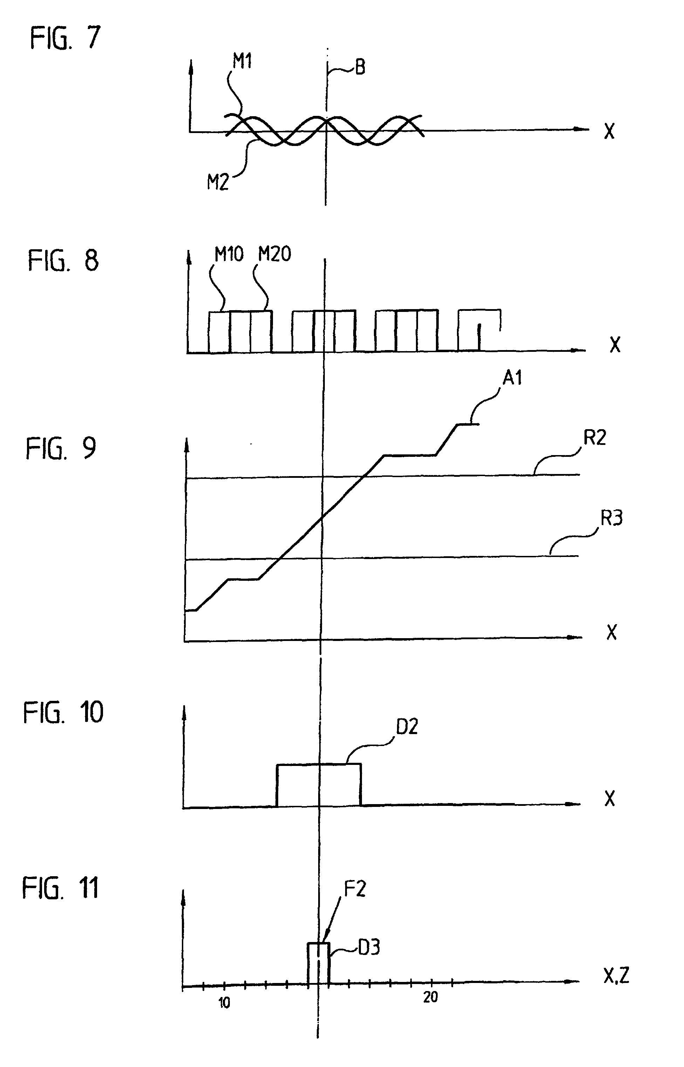

Anhand der Figuren 7 bis 12 ist ein weiteres Ausführungsbeispiel erläutert. Es wird gezeigt, wie aus dem analogen Abtastsignal A1 ein Signal D3 gebildet werden kann, das ein Merkmal F2 aufweist, welches einem Zählschritt Z der inkrementalen Teilung 3 eindeutig zugeordnet ist. Hierzu werden aus den in Figur 7 nochmals dargestellten analogen Meßsignalen M1, M2 zwei um 90° gegeneinander phasenverschobene digitale Meßsignale M10, M20 gebildet (Figur 8). Durch diese Digitalisierung wird eine Periode TP in mehrere Bereiche aufgeteilt. Diese Aufteilung in beispielsweise vier Bereiche ist bereits eine Interpolation. Jeder dieser Bereiche entspricht wiederum einem Zählschritt Z.

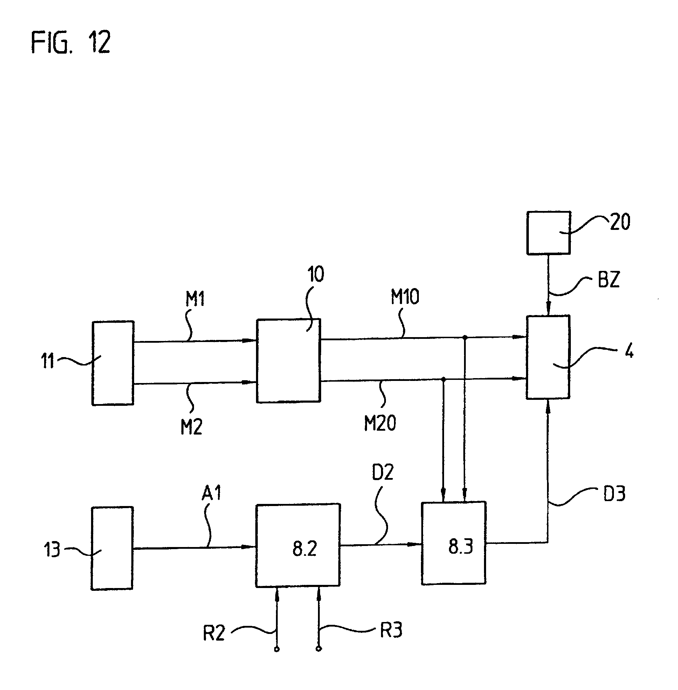

In Figur 9 ist das analoge Abtastsignal A1 der Bezugsspur 5 dargestellt. Dieses Abtastsignal A1 wird in einem in Figur 12 gezeigten Vergleicher 8.2 mit zwei Referenzsignalen R2, R3 verglichen, wodurch ein digitales Signal D2 erzeugt wird. Durch logische UND-Verknüpfung von M10 und M20 und D2 wird das Signal D3 erzeugt, dessen High-Pegel F2 eine Breite aufweist, die der Breite eines Zählschrittes Z entspricht und somit einem Zählschritt Z eindeutig zugeordnet ist. Die logische Verknüpfung erfolgt in der Logikschaltung 8.3 (Figur 12).

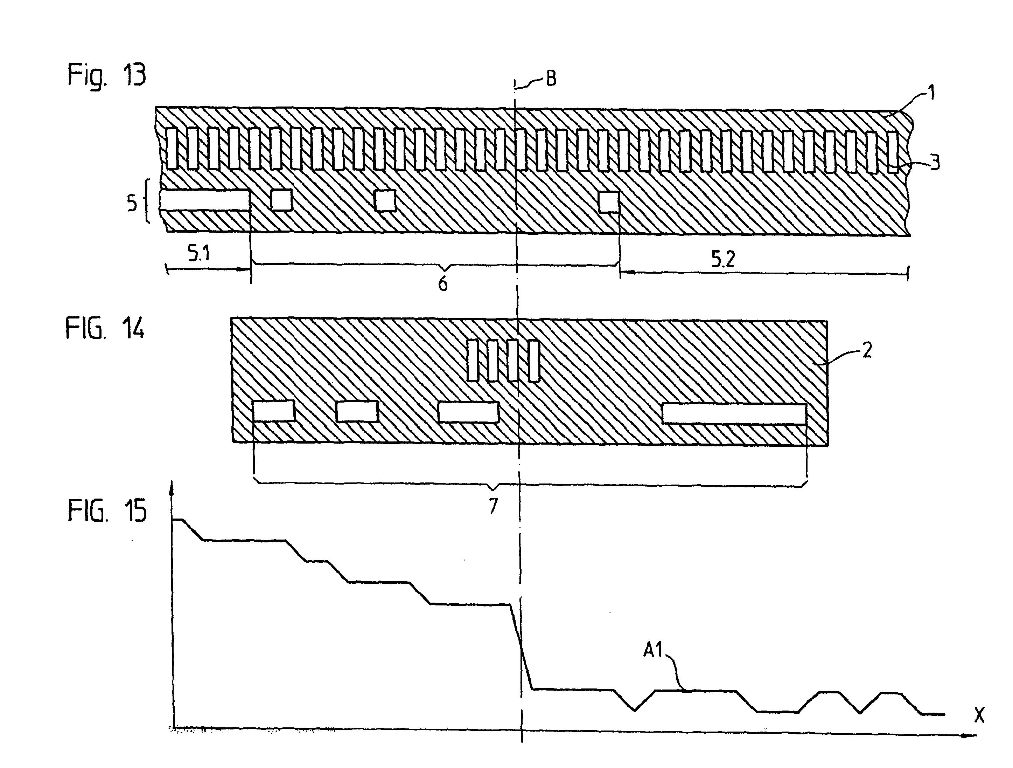

In den beschriebenen Beispielen entspricht einem Zählschritt Z = 0,25 x TP. Werden die von der Abtasteinheit 2 gewonnenen analogen Meßsignale weiter interpoliert, so kann Z auch ein kleinerer Bruchteil von TP sein, z.B. kann Z = 0,05 x TP oder 0,02 x TP sein. Um auch bei diesen kleinen Zählschritten Z die Bezugsposition B aus dem Abtastsignal A1 eindeutig einem bestimmten Zählschritt zuordnen zu können, müssen eine Vielzahl von Feldern 6.1 zum Anstieg des Abtastsignales A1 im Bereich der Bezugsposition B beitragen. Ein Beispiel für einen dazu ausgebildeten Maßstab 1 ist in Figur 13 dargestellt. Die entsprechend dazu ausgebildete Abtasteinheit 2 ist in Figur 14 gezeigt. Das bei der Relativbewegung zwischen dem Maßstab 1 und der Abtasteinheit 2 erzeugte analoge Abtastsignal A1 ist in Figur 15 dargestellt.

In allen Figuren 1 bis 18 wurden für gleichwirkende Teile gleiche Bezugszeichen gewählt.

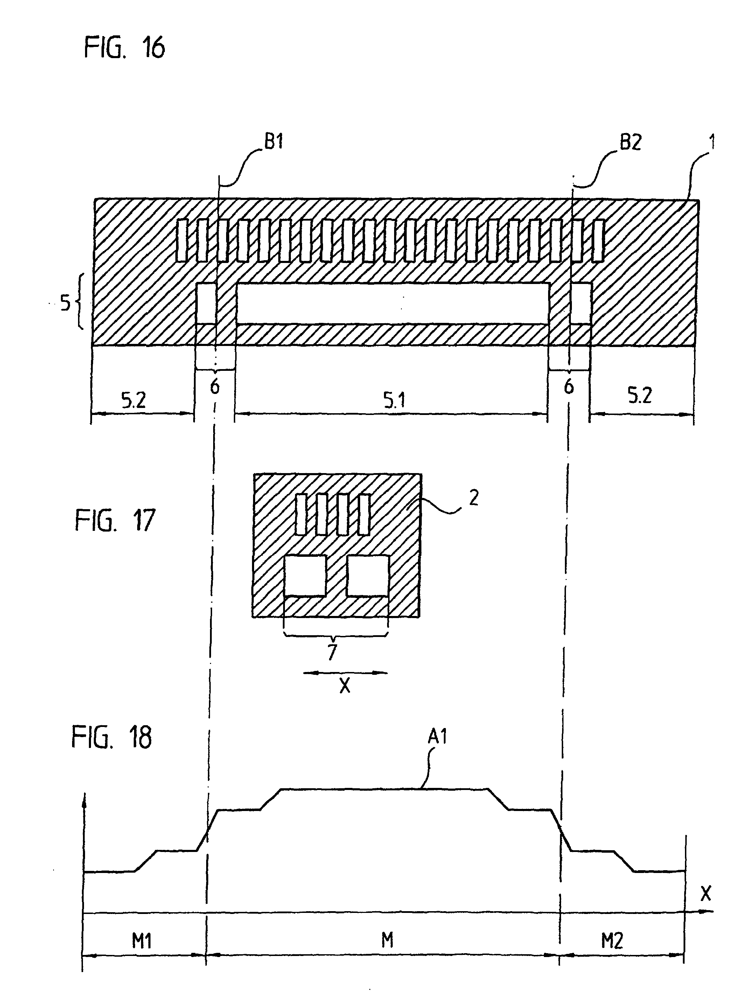

Bei den bisher erläuterten Beispielen wird entlang des Maßstabes 1 nur an einer Bezugsposition B ein Referenzmarkensignal F1, F2 erzeugt. Gemäß der Erfindung können aber auch mehrere Bezugspositionen B definiert werden. Ein Beispiel hierzu ist in den Figuren 16 bis 18 dargestellt. Der Maßstab 1 weist zwei Bezugspositionen B1, B2 auf. Die Muster 6 des Maßstabes 1 und das Muster 7 der Abtasteinheit 2 sind entsprechend Figur 1 und 2 ausgebildet, so daß sich weitere Erläuterungen dazu erübrigen. Wenn die Abtasteinheit 2 relativ zum Maßstab 1 in Meßrichtung X verschoben wird, entsteht das in Figur 18 dargestellte Abtastsignal A1. Die Bezugspositionen B1, B2 definieren die Grenzen des zulässigen Meßbereiches des Maßstabes 1. Sie dienen dazu, um einen Meßbereich M und Endlagenbereiche M1, M2 zu bestimmen. Das Abtastsignal A1 kann dazu dienen, eine Antriebseinheit bei Erreichen der Endlagenbereiche M1, M2 abzuschalten, um Kollisionen von Maschinenteilen zu vermeiden.

In nicht gezeigter Weise können die transparenten Bereiche 6.1 der Abtastplatte 2 auch direkt als lichtempfindliche Bereiche eines Photodetektors und die opaken Bereiche 6.2 als nicht lichtempfindliche Zwischenräume ausgebildet sein.

Bei allen erläuterten Beispielen erfolgt eine lichtelektrische Abtastung des Maßstabes 1 im Durchlicht. Die Erfindung ist aber auch bei Auflicht-Abtastung sowie bei anderen physikalischen Abtastprinzipien einsetzbar, wie beispielsweise kapazitiv oder magnetisch.

## Patentansprüche

1. Positionsmeßeinrichtung mit
- einem Maßstab (1) auf dem eine inkrementale Teilung (3) mit einer Teilungsperiode (TP) vorgesehen ist.
- einer relativ zum Maßstab (1) in Meßrichtung (x) bewegbaren Abtasteinheit (2), die die inkrementale Teilung (3) zur Erzeugung von positionsabhängigen Meßsignalen (M1, M2) abtastet,
- einer Interpolationseinheit (10), welcher die Meßsignale (M1,M2) zugeführt werden und in der jede Teilungsperiode (TP) in mehrere Bereiche aufgeteilt wird, wobei jeder Bereich einem Zählschritt (Z) entspricht,
- einem Zähler (4) zum Summieren der Zählschritte (Z) bei der Abtastung der inkrementalen Teilung (3),
- einer Bezugsspur (5), welche auf einer Seite einer Bezugsposition (B) ein erstes Feld (5.1) und auf der anderen Seite ein davon unterschiedliches zweites Feld (5.2) aufweist, die von einem Muster (7) mit ersten und zweiten Bereichen (7.1, 7.2) der Abtasteinheit (2) abtastbar ist, wobei bei der Abtastung des ersten Feldes (5.1) ein kontinuierlich hohes und des zweiten Feldes (5.2) ein kontinuierlich niedriges Abtastsignal (A1) erzeugt wird, wobei an der Bezugsposition (B) zwischen den ersten und zweiten Feldern (5.1, 5.2) ein Muster (6) vorgesehen ist, das aus einer Folge von ersten und zweiten Feldern (6.1, 6.2) besteht, und dieses Muster (6) von dem Muster (7) der Abtasteinheit (2) abgetastet wird, das aus einer Folge von jeweils mehreren ersten und zweiten Bereichen (7.1, 7.2) besteht, wobei von der Abtasteinheit (2) ein Abtastsignal (A1) erzeugt wird, das zu dem Maß der Überlappung zwischen ersten Feldern (5.1, 6.1) und ersten Bereichen (7.1) proportional ist und die Muster (6, 7) derart dimensioniert sind, daß bei der Bewegung der Abtasteinheit (2) von einer Seite der Bezugsposition (B) zur anderen Seite ein steiler Anstieg des Abtastsignals (A1) erfolgt, indem gleichzeitig mehrere erste Felder (5.1, 6.1) mit ersten Bereichen (7.1) vom sich nicht überlappenden Zustand in einen sich überlappenden Zustand übergehen, und daß bei der weiteren Abtastung des Musters (6) das Maß der Überlappung immer größer ist, als bei der Abtastung des Musters (6) vor der Bezugsposition (B),
- einem Baustein (8), welchem das Abtastsignal (A1) der Bezugsspur (5) zugeführt wird, und welcher das Abtastsignal (A1) mit zumindest einem Referenzsignal (R) vergleicht und ein Signal (D) bildet, das ein Merkmal (F) aufweist, welches einem Zählschritt (Z) der inkrementalen Teilung (3) eindeutig zugeordnet ist und dieser Zählschritt (Z) die Bezugsposition (B) für die inkrementale Messung definiert, indem beim Auftreten des Merkmals (F) der Zählerstand des Zählers (4) auf einen vorgegebenen Wert (BZ) gesetzt wird und der Pegel des Abtastsignals (A1) auf der einen Seite der Bezugsposition (B) kontinuierlich über eine Vielzahl von Teilungsperioden (TP) vom Signalpegel auf der anderen Seite der Bezugsposition (B) abweicht.

2. Positionsmeßeinrichtung nach Anspruch 1, **dadurch gekennzeichnet, daß** der Baustein ein Vergleicher (8.1) ist, welchem das Abtastsignal (A1) der Bezugsspur (5) sowie ein Referenzsignal (R1) zugeführt werden, und der ein Signal (D1) mit einer Flanke (F1) bildet, welche dem die Bezugsposition definierenden Zählschritt (BZ) eindeutig zugeordnet ist.

3. Positionsmeßeinrichtung nach Anspruch 1, **dadurch gekennzeichnet, daß** der Baustein einen Vergleicher (8.2) aufweist, welchem das Abtastsignal (A1) der Bezugsspur (5) sowie zwei Referenzsignale (R2, R3) zugeführt werden, und der durch Vergleich des Abtastsignals (A1) mit den Referenzsignalen (R2, R3) ein Signal (D2) bildet, und daß der Baustein weiterhin eine logische Schaltung (8.3) aufweist, welche die Meßsignale (M10, M20) der inkrementalen Teilung (3) mit dem im Vergleicher (8.2) gebildeten Signal (D2) logisch verknüpft und dadurch ein resultierendes Signal (D3) mit einem Signalpegel (F2) bildet, welcher dem die Bezugsposition definierenden Zählschritt (BZ) eindeutig zugeordnet ist.

4. Positionsmeßeinrichtung nach einem der vorhergehenden Ansprüche, **dadurch gekennzeichnet, daß** die Abtasteinheit folgende Elemente aufweist:
- eine Lichtquelle (12) zur Beleuchtung der Bezugsspur (5), wobei die ersten Felder (5.1, 6.1) transparent und die zweiten Felder (5.2, 6.2) opak sind;
- eine Abtastplatte (2) mit transparenten ersten Bereichen (7.1) und opaken zweiten Bereichen (7.2);
- einen Photodetektor (13) zum Erfassen des durch die ersten Felder (5.1, 6.1) und die ersten Bereiche (7.1) hindurchtretenden Lichtes.

## Claims

1. Position measuring device, having
- a scale (1) on which an incremental division (3) with a division period (TP) is provided,
- a scanning unit (2) which is movable relative to the scale (1) in the measuring direction (X) and scans the incremental division (3) in order to generate position-dependent measurement signals (M1, M2),
- an interpolation unit (10) to which the measurement signals (M1, M2) are supplied and in which each division period (TP) is divided into a plurality of regions, each region corresponding to one meter step (Z),
- a meter (4) for adding the meter steps (Z) during scanning of the incremental division (3),
- a reference track (5) which has on one side of a reference position (B) a first field (5.1) and, on the other side, a second field (5.2) which is distinguishable therefrom, said reference track (5) being scannable by a pattern (7) with first and second regions (7.1, 7.2) of the scanning unit (2), a continuously high scanning signal being generated during scanning of the first field (5.1) and a continuously low scanning signal (A1) during scanning of the second field (5.2), a pattern (6) being provided at the reference position (B) between the first and second fields (5.1, 5.2) which comprises a sequence of first and second fields (6.1,6.2) and this pattern (6) being s canned by t he pattern ( 7) o f the s canning u nit ( 2) which comprises a sequence of respectively a plurality of first and second regions (7.1, 7.2), a scanning signal (A1) being generated by the scanning unit (2) which is proportional to the dimension of the overlapping between first fields (5.1, 6:1 ) and first regions (7.1) and the patterns (6, 7) being dimensioned such that, upon movement of scanning unit (2) from one side of the reference position (B) to the other side, a steep rise of the scanning signal (A1) is effected, in that a plurality of first fields (5.1, 6.1), with first regions (7.1), transcend simultaneously from the non-overlapping state into an overlapping state, and in that, during further scanning of the pattern (6), the dimension of the overlapping is always bigger than during scanning of the pattern (6) before the reference position (B),
- a component (8) to which the scanning signal (A1) of the reference track (5) is supplied and which compares the scanning signal (A1) with at least one reference signal (R) and forms a signal (D) which has a feature (F) which is a assigned unequivocally to one meter step (Z) of the incremental division (3) and this meter step (Z) defines the reference position (B) for the incremental measurement in that, upon occurrence of the feature (F), the meter reading of the meter (4) is set at a prescribed value (BZ) and the level of the scanning signal (A1) on the one side of the reference position (B) differs continuously via a multiplicity of division periods (TP) from the signal level on the other side of the reference position (B).

2. Position measuring device according to claim 1, **characterised in that** the component is a comparator (8.1) to which the scanning signal (A1) of the reference track (5) and a reference signal (R1) are supplied, and which forms a signal (D1) with an edge (F1) which is assigned unequivocally to the meter step (BZ) defining the reference position.

3. Position measuring device according to claim 1, **characterised in that** the component has a comparator (8.2), to which the scanning signal (A1) of the reference track (5) and also two reference signals (R2, R3) are supplied, and which forms a signal (D2) by comparison of the scanning signal (A1) with the reference signals (R2, R3), and **in that** the component has furthermore a logical circuit (8.3) which logically operates the measurement signals (M10, M20) of the incremental division (3) with the signal (D2) formed in the comparator (8.2) and consequently forms a resultant signal (D3) with a signal level (F.2) which is assigned unequivocally to the meter step (BZ) defining the reference position.

4. Position measuring device according to one of the preceding claims, **characterised in that** the scanning unit has the following elements:
- a light source (12) for illuminating the reference track (5), the first fields (5.1, 6.1) being transparent and the second fields (5.2, 6.2) being opaque;
- a scanning plate (2) with transparent first regions (7.1) and opaque second regions (7.2);
- a photodetector (13) for detecting the light penetrating through the first fields (5.1, 6.1) and the first regions (7.1).

## Revendications

1. Dispositif de mesure de position comprenant
- une règle graduée (1) sur laquelle est disposée une division incrémentale (3) avec une période de division (TP),
- une unité de palpage (2) mobile par rapport à la règle graduée (1) dans la direction de mesure (X), qui palpe la division incrémentale (3) aux fins de produire des signaux de mesure (M1, M2) dépendant de la position,
- une unité d'interpolation (10) à laquelle sont transmis les signaux de mesure (M1, M2) et dans laquelle chaque période de division (TP) est divisée en plusieurs zones, chaque zone correspondant à un pas de comptage (Z),
- un compteur (4) pour additionner les pas de comptage (Z) lors du palpage de la division incrémentale (3),
- une piste de référence (5) qui d'un côté d'une première position de référence (B) présente un premier champ (5.1) et de l'autre côté un second champ (5.2), différent du premier, et qui peut être palpée par un modèle (7) avec des premières et deuxièmes zones (7.1, 7.2) de l'unité de palpage (2), dans lequel un signal de palpage (A1) respectivement continument élevé et continument faible est produit lors du palpage du premier champ (5.1) et du second champ (5.2), dans lequel il est prévu au niveau de la position de référence (B) entre les premier et second champs (5.1, 5.2), un modèle (6) qui est formé d'une succession de premiers et deuxièmes champs (6.1, 6.2) et est palpé par le modèle (7) de l'unité de palpage (2), lui-même formé d'une succession de premières et deuxièmes zones (7.1, 7.2), dans lequel l'unité de palpage (2) produit un signal de palpage (A1), qui est proportionnel à la valeur du chevauchement entre les premiers champs (5.1, 6.1) et les premières zones (7.1), et les modèles (6, 7) sont dimensionnés de telle sorte que, lors du déplacement de l'unité de palpage (2) d'un côté de la position de référence (B) à l'autre côté, il se produise une montée brusque du signal de palpage (A1), plusieurs premiers champs (5.1, 6.1) passant simultanément d'un état de non-chevauchement à un état de chevauchement avec des premières zones (7.1) et que lors de la poursuite du palpage du modèle (6) la valeur du chevauchement est toujours supérieure à celle obtenue lors du palpage du modèle (6) avant la position de référence (B),
- un composant (8) auquel le signal de palpage (A1) de la piste de référence est transmis et qui compare ledit signal de palpage (A1) à au moins un signal de référence (R) et forme un signal (D) qui présente une caractéristique (F) associée de manière univoque à un pas de comptage (Z) de la division incrémentale (3), et lequel pas de comptage (3) définit la position de référence (B) pour la mesure incrémentale en amenant, lors de l'apparition de la caractéristique (F), la position du compteur (4) sur une valeur prédéterminée (BZ) et le niveau du signe de palpage (A1) d'un côté de la position de référence (B) s'écartant de manière permanente sur plusieurs périodes de division (TP) du niveau de signal de l'autre côté de la position de référence (B).

2. Dispositif de mesure de position selon la revendication 1, **caractérisé en ce que** le composant est un comparateur (8.1), auquel sont transmis le signal de palpage (A1) de la piste de référence (5) ainsi qu'un signal de référence et qui forme un signal (D1) avec un flanc (F1) associé de manière univoque au pas de comptage (BZ) définissant la position de référence.

3. Dispositif de mesure de position selon la revendication 1, **caractérisé en ce que** le composant est un comparateur (8.2) auquel sont transmis le signal de palpage (A1) de la piste de référence (5) ainsi que deux signaux de référence (R2, R3) et qui, par comparaison du signal de palpage (A1)avec les signaux de référence (R2, R3), forme un signal (D2), et **en ce que** le composant comprend également un circuit logique (8.3) qui combine de manière logique les signaux de mesure (M10, M20) de la division incrémentale (3) et le signal (D2) formé dans le comparateur (8.2) et forme un signal résultant (D3) avec un niveau de signal (F2) associé de manière univoque au pas de comptage (BZ) définissant la position de référence.

4. Dispositif de mesure de position selon une des revendications précédentes, **caractérisé en ce que** l'unité de palpage comprend les éléments suivants:
- une source lumineuse (12) pour éclairer la piste de référence (5), les premiers champs (5.1, 6.1) étant transparents et les deuxièmes champs (5.2, 6.2) étant opaques,
- une plaque de palpage (2) avec des premières zones (7.1) transparentes et des deuxièmes zones (7.2) opaques,
- un détecteur photoélectrique (13) pour détecter la lumière traversant les premiers champs (5.1, 6.1) et les premières zones (7.1).
